Europäisches Patentamt

European Patent Office

Office européen des brevets

(11) Veröffentlichungsnummer: **0 382 274 B1**

## EUROPÄISCHE PATENTSCHRIFT

(45) Veröffentlichungstag der Patentschrift: **20.04.94**

(51) Int. Cl.⁵: **G01R 15/04**, G01R 15/06

(21) Anmeldenummer: **90200158.5**

(22) Anmeldetag: **22.01.90**

(54) Anordnung zur Hochspannungsmessung.

(30) Priorität: **26.01.89 DE 3902263**

(43) Veröffentlichungstag der Anmeldung:
**16.08.90 Patentblatt 90/33**

(45) Bekanntmachung des Hinweises auf die
Patenterteilung:
**20.04.94 Patentblatt 94/16**

(84) Benannte Vertragsstaaten:
**DE FR GB**

(56) Entgegenhaltungen:
**DE-B- 2 833 036**
**FR-A- 2 506 947**

**ELEKTROTECHNISCHE ZEITSCHRIFT A, Band
94, Nr. 2, Februar 1973, Seiten 91-94; W.
PFEIFFER: "Aufbau und Anwendung kapazitivier Spannungsteiler extrem kurzer Anstiegszeit für gasisolierte Koaxialsysteme"**

(73) Patentinhaber: **Philips Patentverwaltung
GmbH
Wendenstrasse 35c
D-20097 Hamburg(DE)**

(84) Benannte Vertragsstaaten:
**DE**

(73) Patentinhaber: **N.V. Philips' Gloeilampenfabrieken
Groenewoudseweg 1
NL-5621 BA Eindhoven(NL)**

(84) Benannte Vertragsstaaten:
**FR GB**

(72) Erfinder: **Negle, Hans
Schwalbenweg 15
D-2061 Nahe(DE)**

(74) Vertreter: **Hartmann, Heinrich, Dipl.-Ing. et al
Philips Patentverwaltung GmbH,
Wendenstrasse 35c
D-20097 Hamburg (DE)**

## Beschreibung

Die Erfindung betrifft eine Anordnung nach dem Oberbegriff des Anspruchs 1.

Eine solche Anordnung ist aus der DE-B 28 33 036 bekannt. Der Hochspannungswiderstand wird dabei durch eine Widerstandsschicht auf einen Isolierkörper gebildet, der als Stützisolator für die Innenelektrode dient. Dieser Isolierkörper umfaßt an seinen der Innenelektrode bzw. der Außenelektrode zugewandten Enden Abschnitte, deren Oberfläche senkrecht zur Innenelektrode verläuft und die über einen Abschnitt verbunden sind, der sich zur Innenelektrode hin trichterförmig verjüngt.

Bei Röntgengeneratoren werden Anordnungen zur Hochspannungsmessung benötigt, deren Übertragungsverhalten möglichst frequenzunabhängig ist. Diesen Anforderungen genügt die bekannte Anrodnung nur bedingt.

Aufgabe der vorliegenden Erfindung ist es, eine Anordnung der eingangs genannten Art so auszugestalten, daß sie eine große Übertragungsbandbreite aufweist.

Diese Aufgabe wird erfindungsgemäß durch die im Anspruch 1 angegebenen Maßnahmen gelöst.

Die Erfindung beruht auf der Erkenntnis, daß in einer koaxialen Elektrodenanordnung mit einer auf Hochspannungspotential liegenden Innenelektrode sich das elektrostatische Potential mit dem Logarithmus des Abstandes von der Innenelektrode zur Außenelektrode hin abbaut. Auf der anderen Seite ruft ein Stromfluß durch eine gleichmäßig dicke kegelmantelförmige Widerstandsschicht einen Spannungsabfall an dem Widerstand hervor, der sich in gleicher Weise mit den Abstand von der Innenelektrode ändert, wie das elektrostatische Potential. Durch diese verzerrungsfreie Anpassung zwischen dem elektrostatischen Potentialfeld und dem durch den Stromfluß hervorgerufenen Potentialfeld wird erreicht, daß keinerlei Ströme aus dem Hochspannungswiderstand zur Aufladung der parasitären Kapazitäten abfließen müssen. Hierdurch arbeitet der Hochspannungswiderstand bis zu höchsten Frequenzen frequenzunabhängig.

Bei der Anordnung nach der DE-B 28 33 036 hingegen hat das Potential bei einem Stromfluß durch den Hochspannungswiderstand insbesondere im Bereich der Innenelektrode, wo die Feldstärke am höchsten ist, eine andere räumliche Abhängigkeit als das elektrostatische Potential. Bei schnellen Schwankungen der Hochspannung fließen deshalb dielektrische Verschiebungsströme zur Aufladung der parasitären Kapazitäten, so daß sich ein frequenzabhängiges Übertragungsverhalten ergibt.

Der Hochspannungswiderstand kann auf verschiedene Weise realisiert werden. Eine erste Ausgestaltung der Erfindung sieht vor, daß der Hochspannungswiderstand durch einen hohlkegelförmigen selbsttragenden Widerstandskörper gebildet wird. Nach einer anderen Weiterbildung der Erfindung ist vorgesehen, daß der Hochspannungswiderstand durch eine gleichmäßig dicke Widerstandsschicht auf einem hohlkegelförmigen isolierenden Träger gebildet wird. Die letztgenannte Realisierungsform ist aufwendiger, aber auch genauer.

Der Zwischenraum zwischen den beiden Elektroden ist mit einem Isoliermedium gefüllt (z.B. Vakuum, Transformatoröl $SF_6$ oder Kunststoff), dessen Dielektrizitätskonstante von derjenigen des Hochspannungswiderstandes und gegebenenfalls des Trägers, auf dem die Widerstandsschicht angebracht ist, abweicht. Dadurch ergibt sich nicht der gleiche Verlauf des elektrostatischen Potentials wie bei einem homogenen Dielektrikum zwischen Innen- und Außenelektrode, so daß sich Abweichungen zwischen dem elektrostatischen Potentialverlauf und dem durch einen Stromfluß durch den Hochspannungswiderstand hervorgerufenen Potentialverlauf ergeben könen. Diese Abweichungen würden Verschiebungsströme und damit eine größere Frequenzabhängigkeit zur Folge haben. Diese Abweichungen lassen sich durch die in Anspruch 1 angegebenen Maßnahmen kompensieren. Wenn die Dielektrizitätskonstante des Isoliermediums größer ist als die des Widerstandes und gegebenenfalls des Trägerkörpers, dann muß der Durchmesser der Innenelektrode vom Verbindungsbereich ab zunehmen; anderenfalls muß er abnehmen.

Der Hochspannungswiderstand kann - ebenso wie bei der eingangs erwähnten bekannten Anordnung - Teil eines Meßspannungsteilers sein. Er kann aber auch allein zur Messung benutzt werden, indem beispielsweise der ihn durchfließende Strom gemessen wird. Wenn er als Teil eines Meßspannungsteilers eingesetzt wird, kann die durch die Erfindung bewirkte Verbesserung des Hochfrequenzverhaltens aber nicht voll ausgenutzt werden, wenn dem nicht eine adäquate Gestaltung des Meßwiderstandes gegenübersteht. Eine in dieser Hinsicht geeignete Weiterbildung ergibt sich dadurch, daß der von der Innenelektrode abgewandte Rand des Hochspannungswiderstandes über ein trichterförmiges Kontaktierungselement mit einer den Meßwiderstand bildenden Widerstandsschicht auf der Innenfläche eines Hohlzylinders verbunden ist und daß der Verbindungsbereich zwischen dieser Schicht und dem Kontaktierungselement mit dem Innenleiter und das davon abgewandte Ende des Meßwiderstandes mit dem Außenleiter eines Koaxialkabels verbunden ist. Der Abgriff des Spannungsteilers ist dabei in das von magnetischen Feldern freie Gebiet innerhalb des hohlzylindrischen Meßwiderstandes verlegt.

Die Erfindung wird nachstehend an Hand der Zeichnungen näher erläutert. Es zeigen:

Fig. 1 eine Ausführungsform der Erfindung, bei der die Messung mittels eines konzentrisch zur Außenelektrode angeordneten Koaxialkabels erfolgt,

Fig. 2 eine Ausführungsform, bei der die Anordnung im Zuge eines Hochspannungskabels angebracht ist.

Eine rohr- bzw. hohlzylinderförmige geerdete Außenelektrode 1 umschließt eine dazu konzentrisch angeordnete zumindest annähernd zylinderförmige Innenelektrode 2, die im Betrieb Hochspannungspotential führt. Wenn der Innendurchmesser der Außenelektrode etwa das 2,7-fache des Durchmessers der Innenelektrode beträgt, ergibt sich die geringstmögliche elektrische Feldstärke (wenn die Abmessungen der Außenelektrode und die Hochspannung vorgegeben sind).

Mit der Innenelektrode ist ein koaxial dazu angeordneter selbsttragender Widerstandskörper mit konstanter Wandstärke und homogenem spezifischen Widerstand verbunden. Dieser Widerstandskörper hat die Form eines Hohlkegels, d.h. seine Mantelflächen verlaufen in einem die Symmetrieachse der Anordnung enthaltenden Querschnitt geradlinig. Der in den Widerstandskörper 3 hineinragende Abschnitt der Innenelektrode 2 ist ungefähr so lang wie der Widerstandskörper. Der Verbindungsbereich der Innenelektrode 2 mit dem Widerstandskörper 3 wird durch eine linsenförmige Metallkappe 4 abgeschirmt, deren Außenfläche ohne Durchmessersprung in die Außenfläche des Widerstandskörpers 3 übergeht.

Wenn man annimmt, daß die Länge der koaxialen Anordnung 1,2 groß im Vergleich zu ihrem Durchmesser ist und den Träger 3 außer acht läßt, ergibt sich zwischen den beiden Elektroden ein elektrostatisches Feld, dessen Potential sich logarithmisch mit dem Abstand von der Symmetrieachse 5 ändert. Der gleiche Potentialverlauf ergibt sich auch auf der Oberfläche eines gleichmäßig dicken Widerstandskörpers, der auf einer die beiden Elektroden miteinander verbindenden koaxialen Kegelmantelfläche angeordnet ist, wenn diese Schicht von einem über die Innenelektrode zur Außenelektrode fließenden Strom durchflossen wird. Diese Ausbildung des Hochspannungswiderstandes hat zur Folge, daß über den Widerstand keine Ladeströme fließen, so daß die Impedanz des Hochspannungswiderstandes weitgehend frequenzunabhängig ist. Dies gilt auch für die in der Zeichnung dargestellte Ausführungsform, bei der der von der Innenelektrode abgewandte Rand des Innenwiderstandes nicht ganz die Außenelektrode 1 erreicht, bei der dieser Rand jedoch - wie noch nachfolgend erläutert - über einen im Vergleich zum Hochspannungswiderstand elektrisch kleinen Widerstand mit dem Potential der Außenelektrode (Erde) verbunden ist.

Wenn der Widerstandskörper 3 selbsttragend sein soll, kann eine gewisse Wandstärke in der Regel nicht unterschritten werden. Berücksichtigt man aber, daß der Widerstandskörper relativ kurz ist und daß der Hochspannungswiderstand sehr groß sein muß (z.B. 100 MOhm oder mehr), dann ergibt sich, daß der Widerstandskörper aus einem Material mit einem außerordentlich hohen spezifischen Widerstand bestehen muß. Hierfür eignen sich keramische Massen, die gegebenenfalls geringfügig dotiert sind. Dem Vorteil, daß mit einem solchen Material relativ leicht ein zumindest annähernd gleichmäßig dicker selbsttragender Widerstandskörper hergestellt werden kann, steht der Nachteil gegenüber, daß ein solches Material relativ stark von der Temperatur abhängt.

Zwar gibt es Widerstandsmaterialien mit einer geringeren Temperaturabhängigkeit, doch ist deren spezifischer Widerstand wesentlich geringer. Um den gleichen Widerstand zu realisieren, muß die Dicke der Widerstandsschicht daher wesentlich geringer sein, so daß damit hergestellte Hochspannungswiderstände nicht als selbsttragende Widerstandskörper ausgeführt sein können; vielmehr muß die Widerstandsschicht auf einen hohlkegelförmigen Trägerkörper, beispielsweise aus einer isolierenden Keramik, aufgebracht werden. Dabei können örtliche Abweichungen von der Sollstärke der Schicht von nur wenigen μm zu Feldverzerrungen führen, die ihrerseits parasitäre Ströme und damit ein frequenzabhängiges Übertragungsverhalten zur Folge haben. Die Beschichtung kann daher nicht mit einem einfachen Siebdruckverfahren erfolgen, sondern muß durch CVD-, Sputter oder andere wesentlich teuere Verfahren erfolgen oder die Gleichmäßigkeit der Schicht muß durch eine aufwendige Nachbearbeitung erreicht werden. Die geringere Temperaturabhängigkeit wird also durch höhere Fertigungskosten erkauft.

Wenn die gleichmäßig dicke Widerstandsschicht sich nicht auf einem Hohlkegel befinden würde, sondern auf einem anderen rotationssymmetrischen Körper, könnte der gleiche Potentialverlauf auf der Oberfläche des Widerstandes als Funktion des Abstandes von der Innenelektrode erreicht werden, wenn die Dicke und/oder der spezifische Widerstand der Widerstandsschicht in Abhängigkeit von dem Radius geändert würde. Da eine derartige Schicht aber sehr schwer herzustellen ist, wird die Kegelform mit einer gleichmäßig dicken homogenen Widerstandsschicht bevorzugt.

Wenn der Trägerkörper relativ dick ist im Vergleich zur Widerstandsschicht ist und aus einem Material besteht, dessen Dielektrizitätskonstante wesentlich von der Dielektrizitätskonstanten des Isoliermediums (Vakuum, Schwefelhexafluorid, Transformatoröl oder Kunststoff) abweicht, ändert sich das elektrostatische Potential nicht mehr mit dem Logarithmus des Abstandes von der Innenelektrode. Der elektrostatische Potentialverlauf und der durch den Stromfluß durch den Hochspannungswiderstand bedingte Potentialverlauf stimmen in diesem Fall also nicht mehr vollständig überein.

Eine verbesserte Übereinstimmung läßt sich dadurch erreichen, daß der Radius r der Innenelektrode in Abhängigkeit von dem Abstand s der Innenfläche des Widerstandskörpers von der Symmetrieachse 5 nach der Gleichung

$$r = r_o \cdot (s/(s - d/\cos\beta)) \qquad (1)$$

gewählt wird. d ist dabei die Dicke des Widerstandskörpers und $\beta$ ist der Winkel, unter dem eine Mantellinie dieses Körpers die Symmetrieachse 5 schneidet. $r_o$ ist der halbe Durchmesser der Kappe 4 im Übergangsbereich zum Widerstandskörper 3, und der Exponent x errechnet sich nach der Beziehung

$$x = E_1/E_2 - 1 \qquad (2)$$

$E_1$ ist dabei die Dielektrizitätskonstante des Isoliermediums zwischen den beiden Elektroden. $E_2$ ist die Dielektrizitätskonstante des Widerstandskörpers.

Aus den Gleichungen 1 und 2 ergibt sich, daß der Radius der Innenelektrode vom Verbindungsbereich des Hochspannungswiderstandes mit der Innenelektrode ausgehend zunehmen muß, wenn $E_2$ größer ist als $E_1$. Diese Zunahme liegt im Prozentbereich des Innendurchmessers. Stattdessen kann aber auch der Innendurchmesser der Außenelektrode geändert werden, um die gewünschte Potentialangleichung zu erhalten. Sie ist dann - zumindest auf ihrer Innenfläche - nur annähernd zylinderförmig; die Änderung ist gegensinnig zu der nach den Gleichungen 1 und 2 errechneten Änderung.

Das offene Ende des Widerstandskörpers (wenn davon ausgegangen wird, daß der Hochspannungswiderstand durch einen selbsttragenden Hohlkegel aus Widerstandsmaterial gebildet wird), ist mechanisch mit dem entsprechenden Ende eines weiteren hohlkegelförmigen Trägers 6 verbunden. Dieser verjüngt sich also von der Verbindungsstelle ausgehend, bis er in einen Flansch 7 mit konstantem Durchmesser übergeht. Der Trägerkörper 6, der aus Keramik bestehen kann, ist auf seiner Außenfläche metallisiert, wobei diese Metallisierung über die Außenelektrode 1 geerdet ist. Die Innenfläche des Trägerkörpers 6 ist ebenfalls metallisiert und dient als Verbindungsleitung zwischen dem durch den Widerstandskörper 3 gebildeten Hochspannungswiderstand und einem Meßwiderstand, der durch eine Widerstandsschicht 8 auf der Innenseite des hohlzylindrischen Teils 7 gebildet wird. Es versteht sich von selbst, daß auch der Meßwiderstand 8 durch einen hohlkegelförmigen Widerstandskörper gebildet werden kann. Der Meßwiderstand 8 ist auf seinem von der Innenelektrode 2 abgewandten Rand geerdet, während sein der Innenelektrode zugewandter Rand durch eine leitende kreisförmige Scheibe 9 abgeschlossen wird. Der Mittelpunkt dieser Scheibe ist mit dem Innenleiter 10 eines Koaxialkabels verbunden, dessen Außenleiter an Erde angeschlossen ist.

Der Hochspannungswiderstand 4 und der Meßwiderstand 8 bilden zusammen einen Meßspannungsteiler, der die Hochspannung in einem definierten Verhältnis, beispielsweise 1: 10.000 teilt. Die an dem Abgriff (Scheibe 9) abgegriffene Spannung kann zu Meß- oder Regelzwecken benutzt werden. Durch diesen Aufbau ist der Innenleiter 10 des Koaxialkabels 11 von Störsignalen weitgehend abgeschirmt - insbesondere wenn das offene Ende der Außenelektrode 1 durch das gestrichelt angedeutete geerdete Metallschild 15 abgeschirmt wird. Wird dies Metallschild mit einer zweiten Abschirmung eines Koaxialkabels verbunden, ergibt sich ein doppelt geschirmter Aufbau. Der durch die Hochspannung an dem Meßspannungsteiler in dem Meßwiderstand hervorgerufene Meßstrom fließt dabei axialsymmetrisch über den Widerstand, woraus sich ein besonders induktivitätsarmer Meßaufbau ergibt. Mittels einer kugelkappenförmigen geerdeten Schutzelektrode 12, die mit dem Endteil des Trägerkörpers 3 verbunden ist, können Überschläge zwischen der Innenelektrode und der Scheibe 9 verhindert werden.

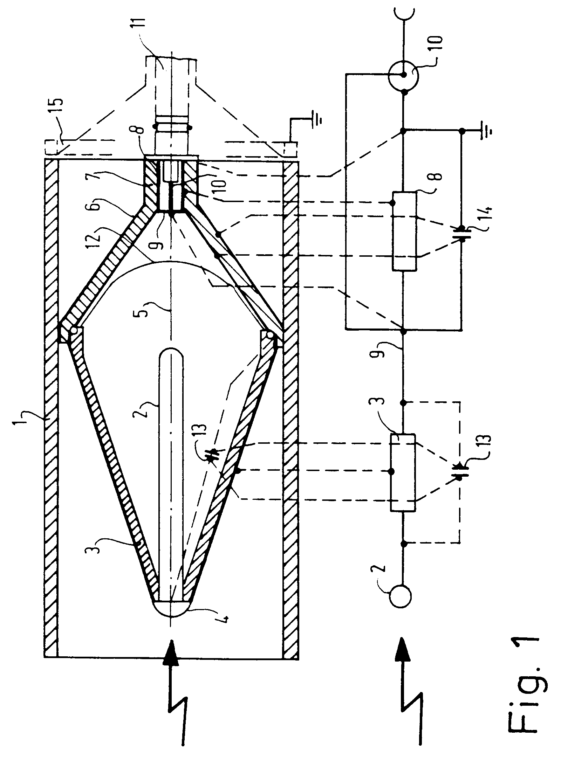

Wie in der Zeichnung durch gestrichelte Linien angedeutet, lassen sich Längskapazitäten zwischen der Innenelektrode und dem Meßspannungsteilerabgriff nicht ganz vermeiden. Die daraus resultierende Kapazität 13 liegt dem Hochspannungswiderstand 3 parallel. Die Kapazität kann bei hohen Frequenzen zu einer Änderung des Übertragungsfaktors führen. Diese Änderung kann gegebenenfalls mittels einer parallel zum Meßwiderstand 8 wirksamen Kapazität 14 kompensiert werden. Um eine exakte Kompensation zu erreichen, müßte diese Kapazität um soviel größer sein als die Streukapazität 13, wie der Hochspannungswiderstand 3 größer ist als der Meßwiderstand 8. Diese relativ große Kapazität läßt sich dadurch erreichen, daß als Material für den Trägerkörper 6,7 Keramik mit einer relativ großen Dielektrizitätskonstanten (z.B. 100 oder 1000) verwendet wird. Wie aus dem in Fig. 1 eingezeichneten Ersatzschaltbild hervorgeht, ergibt sich dann ein RC-Spannungsteiler, der frequenzunabhängig ist, wenn die Zeitkonstanten der beiden RC-Glieder 3,13 bzw. 8,14 einander gleich sind.

Durch den Meßwiderstand wird die Meßspannung auf z.B. 1 : 10.000 der Hochspannung herabgesetzt. Das elektrostatische Potential am äußersten Rand des Hochspannungswiderstandes kann aber wesentlich höher sein, falls nicht der Durchmesser des Widerstandes an dieser Stelle bis auf wenige mm dem Innendurchmesser der Außenelektrode entspricht. Diese Abweichung zwischen dem elektrostatischen und dem durch den Stromfluß hervorgerufenen Potentialverlauf macht sich aber weder in dem für die Hochspannungsfestigkeit wichtigen Bereich des Widerstandes um die Innenelektrode herum bemerkbar noch wird hierdurch der Frequenzgang wesentlich beeinflußt, da in diesem Bereich keine nennenswerte Spannungsänderung erfolgt. Die Abweichung läßt sich ganz vermeiden, wenn die Außenelektrode im Bereich des äußeren Randes des Trägerkörpers einen ringförmigen Teil mit größerem Durchmesser aufweist, in den der Rand hineinragt. Der Begriff "zylinderförmige Außenelektrode" muß daher im Rahmen der Erfindung so weit interpretiert werden, daß er auch eine solche Ausgestaltung umfaßt.

Die Hochspannung kann der Innenelektrode über einen einzelnen Hochspannungsleiter zugeführt werden, wenn die Anordnung sich beispielsweise innerhalb eines mit einem Isoliermedium gefüllten Generators befindet. Sie kann aber auch über ein Hochspannungskabel zugeführt werden. Wenn dabei darauf geachtet wird, daß die Wellenwiderstände des Koaxialkabels 11 und des Hochspannungskabels einander angepaßt sind, lassen sich bei Auftreten von Wanderwellen Reflexionen und die damit verbundenen Spannungsüberhöhungen vermeiden.

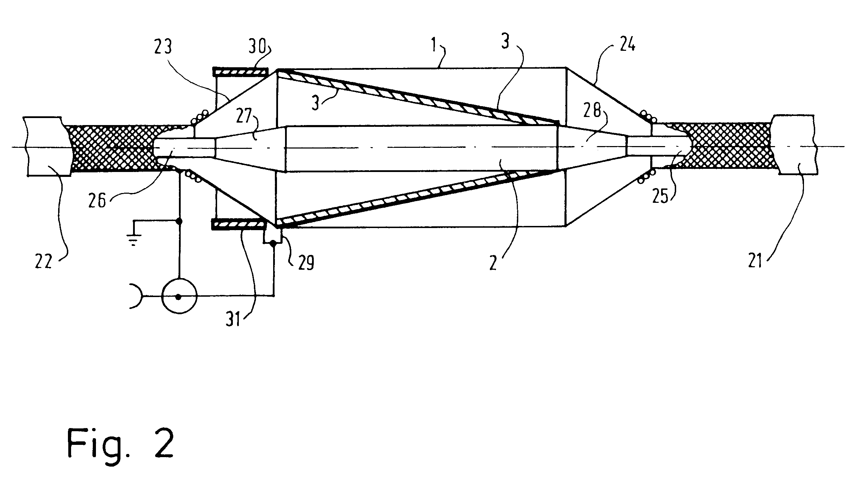

Bei der in Fig. 2 dargestellten Ausführungsform ist die erfindungsgemäße Anordnung zwischen zwei Hochspannungskabeln aufgenommen. Die geerdeten Außenleiter der beiden Hochspannungskabel 21 und 22 gehen in je ein geerdetes hohlkegelförmiges Ansatzstück 23 bzw. 24 über, und zwischen den einander zugewandten Hohlkegeln befindet sich die Außenelektrode 1. Die Innenleiter 25 und 26 der beiden Kabel sind über die Innenelektrode 2 elektrisch miteinander verbunden und weisen konisch sich erweiternde Zwischenstücke 27 und 28 auf, so daß der Wellenwiderstand im Übergangsbereich nicht springt. Der äußere Rand des Hochspannungswiderstandes 3, der durch eine nicht näher dargestellte Isolierfolie elektrisch gegenüber der Außenelektrode 1 isoliert ist, ist über eine geeignete Durchführung 29 mit einem Meßwiderstand verbunden, der durch eine auf den Trägerkörper 30 aufgebrachte Widerstandsschicht 31 gebildet wird. Der Trägerkörper 30 umschließt das kegelförmige Ansatzstück 23 und ist auf seiner Rückseite mit einer Metallisierung versehen, die leitend mit dem Ansatzstück 23 verbunden ist, und die den vom Hochspannungswiderstand 3 abgewandten Rand des Meßwiderstandes 30, 31 kontaktiert.

Der Meßwiderstand bei den in Fig. 1 und 2 dargestellten Ausführungsformen kann entfallen, wenn der Strom über den Hochspannungswiderstand mit einer geeigneten Meßvorrichtung gemessen wird. Aus diesem Meßwert und dem bekannten Wert des Hochspannungswiderstandes läßt sich ebenfalls die Hochspannung bestimmen. Der Rand des Hochspannungswiderstandes kann dabei die Außenelektrode sogar berühren (galvanischer Kontakt).

**Patentansprüche**

1. Anordnung zur Hochspannungsmessung mit einer geerdeten, zumindest annähernd zylinderförmigen Außenelektrode (1) einer dazu koaxialen, zumindest annähernd zylinderförmigen und Hochspannungspotential führenden Innenelektrode (2) und einem zur Innenelektrode (2) konzentrisch angeordneten Hochspannungswiderstand (3) dessen eines Ende mit der Innenelektrode (2) verbunden ist und dessen anderes Ende sich zumindest bis in die Nähe der Außenelektrode (1) erstreckt und mit dieser direkt oder über einen Meßwiderstand (8) verbunden ist, dadurch gekennzeichnet, daß der Hochspannungswiderstand (3) die Form eines gleichmäßigen Kegelmantels aufweist, so daß das Potential bei einem Stromfluß durch den Hochspannungswiderstand (3) zumindest im Bereich der Innenelektrode (2) die gleiche räumliche Abhängigkeit aufweist wie das elektrostatische Potential, daß die Dielektrizitätskonstante des Hochspannungswiderstandes (3) und gegebenenfalls des Trägers von der Dielektrizitätskonstanten des Isoliermediums zwischen der Innen- und der Außenelektrode abweichen und daß die durch die unterschiedlichen Dielektrizitätskonstanten bewirkten Abweichungen des elektrostatischen Potentialverlaufs von dem durch einen Stromfluß durch den Hochspannungswiderstand (3) hervorgerufenen Potentialverlauf durch eine vom Verbindungsbereich der Innenelektrode (2) mit dem Hochspannungswiderstand (3) ausgehende, im Bereich des Kegels liegende, axial kontinuierlich verlaufende Änderung des Durchmessers der Innenelektrode (2) kompensiert wird.

2. Anordnung nach Anspruch 1, dadurch gekennzeichnet, daß der Hochspannungswiderstand (3) durch einen hohlkegelförmigen selbsttragenden Widerstandskörper gebildet wird.

3. Anordnung nach Anspruch 1,
dadurch gekennzeichnet, daß der Hochspannungswiderstand (3) durch eine gleichmäßig dicke Widerstandsschicht auf einem hohlkegelförmigen isolierenden Träger gebildet wird.

4. Anordnung nach einem der Ansprüche 1 bis 3 dadurch gekennzeichnet, daß der Hochspannungswiderstand (3) zusammen mit einem Meßwiderstand (8) einen Meßspannungsteiler bildet, der die beiden Elektroden (1,2) miteinander verbindet.

5. Anordnung nach einem der vorhergehenden Ansprüche,
dadurch gekennzeichnet, daß der von der Innenelektrode (2) abgewandte Rand des Hochspannungswiderstandes (3) über ein trichterförmiges Kontaktierungselement mit einer den Meßwiderstand bildenden Widerstandsschicht (8) auf der Innenfläche eines Hohlzylinders (7) verbunden ist und daß der Verbindungsbereich zwischen dieser Schicht und dem Kontaktierungselement mit dem Innenleiter (10) und das davon abgewandte Ende des Meßwiderstandes mit dem Außenleiter eines Koaxialkabels (11) verbunden ist.

6. Anordnung nach Anspruch 5,
dadurch gekennzeichnet, daß der Hochspannungswiderstand (3) und der Meßwiderstand über einen sich zum Meßwiderstand (8) hin verjüngenden, leitenden Trichter miteinander verbunden sind.

7. Anordnung nach Anspruch 5,
dadurch gekennzeichnet, daß die Hochspannung der Innenelektrode (2) über ein Hochspannungskabel (21,22) zugeführt wird und daß das Hochspannungskabel und das Koaxialkabel (11) zumindest annähernd den gleichen Wellenwiderstand haben.

8. Anordnung nach einem der Ansprüche 1 bis 6, dadurch gekennzeichnet, daß der Innenleiter (2) beidseitig mit einem Hochspannungskabel (21,22) verbunden ist.

9. Anordnung nach Anspruch 8,
dadurch gekennzeichnet, daß der vom Innenleiter abgewandte Rand des Hochspannungswiderstandes mit einem koaxialen Meßwiderstand (31) verbunden ist, dessen Radius größer ist als der Außenradius der Hochspannungskabel (21,22).

10. Anordnung nach einem der Ansprüche 8 oder 9,
dadurch gekennzeichnet, daß die Innenleiter (25,26) und die Außenleiter der Hochspannungskabel (21,22) über kegelförmige Übergangsstücke so an die Innenelektrode (2) und die Außenelektrode (1) angepaßt sind, daß kein Sprung im Wellenwiderstand auftritt.

**Claims**

1. A high-voltage measuring device, comprising a grounded, at least approximately cylindrical outer electrode (1), an at least approximately cylindrical inner electrode (2) which is arranged so as to be coaxial therewith and which carries high-voltage potential, and a high-voltage resistor (3) which is concentrically arranged with respect to the inner electrode (2) and one end of which is connected to the inner electrode (2), its other end extending at least as far as the vicinity of the outer electrode (1) and being connected thereto either directly or via a measuring resistor (8), characterized in that the high-voltage resistor (3) is shaped as a uniform surface of cone so that the potential upon current flow through the high-voltage resistor (3) exhibits the same spatial dependency, at least at the area of the inner electrode (2), as the electrostatic potential, that the dielectric constant of the high-voltage resistor (3), and possibly that of the carrier, deviates from the dielectric constant of the insulating medium between the inner and the outer electrode, and that the deviations of the electrostatic potential which are caused by the different dielectric constants are compensated for by the potential variation, caused by a current flow through the high-voltage resistor (3), through a axially continuous variation of the diameter of the inner electrode (2), commencing from the area of connection of the inner electrode (2) to the high-voltage resistor and situated at the area of the cone.

2. A device as claimed in Claim 1, characterized in that the high-voltage resistor (3) is formed by a hollow conical, self-supporting resistor body.

3. A device as claimed in Claim 1, characterized in that the high-voltage resistor (3) is formed by a resistance layer of uniform thickness provided on a hollow, conical insulating carrier.

4. A device as claimed in any one of the Claims 1 to 3, characterized in that the high-voltage resistor (3) forms, in conjunction with a measuring resistor (8), a measuring voltage divider which interconnects the two electrodes (1, 2).

5. A device as claimed in any one of the preceding Claims, characterized in that the edge of the high-voltage resistor (3) which is remote from the inner electrode (2) is connected, via a funnel-shaped contact member, to a resistance layer (8), forming the measuring resistor, on the inner surface of a hollow cylinder (7), the area of connection between this layer and the contact member being connected to the inner conductor (10) of a coaxial cable (11), the end of the measuring resistor which is remote therefrom being connected to the outer conductor thereof.

6. A device as claimed in Claim 5, characterized in that the high-voltage resistor (3) and the measuring resistor are interconnected by means of a conductive funnel which is tapered in the direction of the measuring resistor (8).

7. A device as claimed in Claim 5, characterized in that the high voltage is applied to the inner electrode (2) via a high-voltage cable (21, 22), the high-voltage cable and the coaxial cable (11) having at least approximately the same characteristic impedance.

8. A device as claimed in any one of the Claims 1 to 6, characterized in that the inner conductor (2) is connected to a high-voltage cable (21, 22) on both sides.

9. A device as claimed in Claim 8, characterized in that the edge of the high-voltage resistor which is remote from the inner conductor is connected to a coaxial measuring resistor (31) whose radius is larger than the outer radius of the high-voltage cable (21, 22).

10. A device as claimed in any one of the Claims 8 or 9, characterized in that the inner conductor (25, 26) and the outer conductor of the high-voltage cable (21, 22) are adapted to the inner electrode (2) and the outer electrode (1) via conical intermediate pieces so that no transient occurs in the characteristic impedance.

**Revendications**

1. Dispositif de mesure de haute tension comportant une électrode externe (1), de forme au moins approximativement cylindrique, mise à la terre, une électrode interne (2) coaxiale avec l'électrode externe, de forme au moins approximativement cylindrique et acheminant un potentiel haute tension, et une résistance haute tension (3) disposée concentriquement par rapport à l'électrode interne (2), une extrémité de la résistance étant connectée à l'électrode interne (2) et l'autre extrémité s'étendant au moins jusqu'au voisinage de l'électrode externe (1) et étant connectée à celle-ci directement ou via une résistance de mesure (8), caractérisé en ce que la résistance haute tension (3) a la forme d'une enveloppe conique uniforme, de sorte que le potentiel présente, lors d'un flux de courant à travers la résistance haute tension (3), au moins dans la zone de l'électrode interne (2), la même dépendance spatiale que le potentiel électrostatique, que les constantes diélectriques de la résistance haute tension (3) et éventuellement du support s'écartent des constantes diélectriques du milieu isolant entre l'électrode interne et l'électrode externe, et que les écarts de la courbe de potentiel électrostatique dus aux constantes diélectriques différentes, vis-à-vis de la courbe de potentiel provoquée par un flux de courant à travers la résistance haute tension (3) sont compensés par une modification du diamètre de l'électrode interne (2) partant de la zone de connexion de l'électrode interne (2) à la résistance haute tension (3), située dans la zone du cône et s'étendant axialement de manière continue.

2. Dispositif selon la revendication 1, caractérisé en ce que la résistance haute tension (3) est formée par un corps résistif autoportant en forme de cône creux.

3. Dispositif selon la revendication 1, caractérisé en ce que la résistance haute tension (3) est formée par une couche résistive d'épaisseur uniforme sur un support isolant en forme de cône creux.

4. Dispositif selon l'une quelconque des revendications 1 à 3, caractérisé en ce que la résistance haute tension (3) forme, conjointement avec une résistance de mesure (8), un diviseur de tension de mesure qui raccorde les deux électrodes (1, 2) l'une à l'autre.

5. Dispositif selon l'une quelconque des revendications précédentes, caractérisé en ce que le bord de la résistance haute tension (3) opposé à l'électrode interne (2) est connecté, via un élément de contact en forme d'entonnoir, à une couche résistive (8) formant la résistance de mesure sur la surface interne d'un cylindre creux (7) et en ce que la zone de connexion entre cette couche et l'élément de contact est connectée au conducteur interne (10) et l'extrémité de la résistance de mesure opposée à celui-ci au conducteur externe d'un câble coaxial (11).

6.    Dispositif selon la revendication 5, caractérisé en ce que la résistance haute tension (3) et la résistance de mesure sont connectées l'une à l'autre via un entonnoir conducteur allant en se rétrécissant vers la résistance de mesure (8).

7.    Dispositif selon la revendication 5, caractérisé en ce que la haute tension est acheminée via un câble haute tension (21, 22) à l'électrode interne (2) et le câble haute tension ainsi que le câble coaxial (11) ont au moins approximativement la même impédance spécifique.

8.    Dispositif selon l'une quelconque des revendications 1 à 6, caractérisé en ce que le conducteur interne (2) est connecté des deux côtés à un câble haute tension (21, 22).

9.    Dispositif selon la revendication 8, caractérisé en ce que le bord de la résistance haute tension opposé au conducteur interne est connecté à une résistance de mesure coaxiale (31), dont le rayon est supérieur au rayon externe du câble haute tension (21, 22).

10.   Dispositif selon l'une ou l'autre des revendications 8 ou 9, caractérisé en ce que le conducteur interne (25, 26) et le conducteur externe du câble haute tension (21, 22) sont adaptés à l'électrode interne (2) et à l'électrode externe (1) via des pièces de transition coniques, de sorte qu'il n'y ait pas de discontinuité dans l'impédance spécifique.

Fig. 1

EP 0 382 274 B1

Fig. 2